(19) Europäisches Patentamt
European Patent Office
Office européen des brevets

(11) **EP 1 981 327 A2**

(12) **EUROPÄISCHE PATENTANMELDUNG**

(43) Veröffentlichungstag:
**15.10.2008 Patentblatt 2008/42**

(51) Int Cl.:
***H05K 13/08*** *(2006.01)*

(21) Anmeldenummer: **08101934.1**

(22) Anmeldetag: **25.02.2008**

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**
Benannte Erstreckungsstaaten:
**AL BA MK RS**

(30) Priorität: **11.04.2007 DE 102007017123**

(71) Anmelder: **SIEMENS AKTIENGESELLSCHAFT**
**80333 München (DE)**

(72) Erfinder: **Eschenweck, Friedrich**
**85622 Feldkirchen (DE)**

(74) Vertreter: **Maier, Daniel Oliver**
**Siemens AG**
**Postfach 22 16 34**
**80506 München (DE)**

(54) **Positionsbestimmung von mit elektronischen Bauelementen befüllten Gebinden in Gebinde-Aufnahmevorrichtung**

(57) Es wird eine Vorrichtung (325) zum Aufnehmen von mit elektronischen Bauelementen befüllten Gebinden (350) beschrieben. Die Vorrichtung weist auf ein Gehäuse (371) und eine Mehrzahl von Aufnahmebereichen (326), die in dem Gehäuse (371) angeordnet sind, wobei in jeweils einen Aufnahmebereich (126, 326, 426) ein mit elektronischen Bauelementen (256) befülltes Gebinde (350) einbringbar ist. Die Vorrichtung (325) weist ferner auf eine Sende- und Empfangseinrichtung (328a), welche derart eingerichtet ist, dass über einen Datenaustausch mit einem an einem bestimmten Gebinde (350) angebrachten kontaktlosen Übertragungselement derjenige Aufnahmebereich (326) identifizierbar ist, in dem sich das bestimmte Gebinde (350) befindet, wobei der Datenaustausch eine Signal-Laufzeitmessung zwischen der Sende- und Empfangseinrichtung (328a) und dem kontaktlosen Übertragungselement umfasst. Es wird ferner ein Zuführsystem (420) zum sequentiellen Bereitstellen von elektronischen Bauelementen (256) sowie eine Bestückvorrichtung (110) beschrieben, welche eine Gebinde-Aufnahmevorrichtung (325) des oben beschriebenen Typs aufweisen. Außerdem wird ein Verfahren zum Überprüfen der Belegung einer Gebinde-Aufnahmevorrichtung (325) mit Gebinden (350) beschrieben, die mit elektronischen Bauelementen (256) befüllt sind und die in Aufnahmebereiche (326) der Gebinde-Aufnahmevorrichtung (325) eingebracht sind.

FIG 3

EP 1 981 327 A2

**Beschreibung**

Die vorliegende Erfindung betrifft die Zuführung von elektronischen Bauelementen für einen Bestückautomaten. Die vorliegende Erfindung betrifft insbesondere eine Vorrichtung zum Aufnehmen von mit elektronischen Bauelementen befüllten Gebinden, bei denen die Position eines Gebindes innerhalb eines Containers der Gebinde-Aufnahmevorrichtung ermittelt werden kann. Die vorliegende Erfindung betrifft ferner ein Zuführsystem zum sequentiellen Bereitstellen von elektronischen Bauelementen sowie eine Bestückvorrichtung, welche eine Gebinde-Aufnahmevorrichtung des oben beschriebenen Typs aufweisen. Außerdem betrifft die vorliegende Erfindung ein Verfahren zum Überprüfen der Belegung einer oben beschriebenen Gebinde-Aufnahmevorrichtung mit Gebinden, die mit elektronischen Bauelementen befüllt sind und die in Aufnahmebereiche der Gebinde-Aufnahmevorrichtung eingebracht sind.

Bei der automatischen Bestückung von Bauelementeträgern bzw. Leiterplatten mit elektronischen Bauelemente werden Bauelementen an Abholpositionen bereitgestellt, von wo sie mittels eines Bestückkopfes abgeholt und auf vorbestimmte Bestückpositionen auf einer Leiterplatte aufgesetzt werden. Um den Bestückungsprozess zu beschleunigen, erfolgt die Zuführung von mehreren elektronischen Bauelemente parallel zu mehreren Abholpositionen, von denen die Bauelemente beispielsweise mittel eines so genannten Mehrfach-Bestückkopfes abgeholt und nach einem gemeinsamen Transport zu einem Bestückbereich nacheinander auf der Leiterplatte aufgesetzt werden.

Um eine fehlerlose Bestückung zu gewährleisten, muss sichergestellt werden, dass auch tatsächlich der jeweils korrekte Bauelement-Typ an der entsprechenden Abholposition bereitgestellt wird. Dies erfolgt im Rahmen einer so genannten Rüstverifikation, bei der beispielsweise unter Verwendung von Barcode-Lesegeräten die Gebinde und damit ein darin befindlicher Typ von Bauelement eindeutig identifiziert wird. Ferner kann eine Zuordnung zwischen einem Gebinde und einer bestimmten Bauelement-Zuführvorrichtung überprüft werden, welche die entsprechenden Bauelemente an jeweils einer fest zugeordneten Abholposition bereitstellen.

Aus der DE 101 19 232 C1 ist es bekannt, als Spulenkörper ausgebildete Gebinde mit jeweils einem RFID-Chip (Radio Frequency Identification-Chip) auszustatten. Auf diese Weise kann mittels einer Funkübertragung zwischen dem RFID-Chip und einer RFID-Leseeinrichtung das jeweilige Gebinde und damit auch die elektronischen Bauelemente, die in einem auf dem Spulenkörper aufgewickelten Bauelement-Gurt aufbewahrt sind, eindeutig identifiziert werden.

Aus der WO 2005/020656 A2 ist ein Zuführsystem für elektronische Bauelemente bekannt, welche in mehreren jeweils auf einem Spulenkörper aufgewickelten Bauelement-Gurten aufbewahrt sind. Die Spulenkörper sind jeweils mit einem RFID-Chip versehen, auf dem bauelementbezogene Daten gespeichert werden können. Um eine Zuordnung zwischen einer bestimmten Zuführspur bzw. einer bestimmten Bauelement-Abholposition auf der einen Seite und einem Spulenkörper-Aufnahmebereich, der in einem sog. Gurtcontainer vorhanden ist, auf der anderen Seite überprüfen zu können, ist in jedem Aufnahmebereich ein RFID-Lesegerät vorgesehen. Auf diese Weise können sowohl die jeweiligen Spulenkörper bzw. die darin befindlichen Bauelemente als auch der jeweilige Spulenkörper-Aufnahmebereich identifiziert werden. Diese Daten können für eine automatische Rüstkontrolle herangezogen werden.

Aus der Schrift US 2004/0193302 A1 ist ein Bestückungsautomat bekannt, welcher eine Mehrzahl an Zuführvorrichtungen für Bauelemente aufweist, wobei die Bauelemente in Bauelement-Gurten, welche auf Spulenkörper aufgewickelt sind, untergebracht sind. Diese Zuführelemente können in Aufnahmebereiche des Bestückungsautomaten eingebracht werden. Der Bestückungsautomat weist auch einen Bestückungskopf auf, auf welchen ein Sende- und Empfangsvorrichtung angebracht ist. Mit dieser Sende- und Empfangsvorrichtung können Daten (z.B. Bauelement-Identifikation, Inventardaten, etc.) aus einem Übertragungselement, beispielsweise einem Datenmodul, welches auf einem Bauelement-Gebinde angebracht ist, kontaktlos ausgelesen werden, wenn der Bestückungskopf in der Nachbarschaft des entsprechenden Übertragungselements positioniert wird. Um eine Zuordnung zwischen einem bestimmten Aufnahmebereich und der darin untergebrachten Bauelement-Gebinde herstellen zu können, ist bei mehreren Aufnahmebereichen allerdings eine genaue Positionierung des Bestückungskopfes notwendig, um das Auslesen eines falschen Übertragungselements (z.B. des Übertragungselements an einer benachbarten Aufnahmeposition) zu verhindern. Außerdem muss für eine Überprüfung einer Belegung der Aufnahmebereiche der Bestückungskopf in aufwendiger und zeitintensiver Weise von einem Bauelement-Gebinde zum nächsten Bauelement-Gebinde geführt werden, um Fehlinformationen beim Auslesen zu verhindern.

Der Erfindung liegt die Aufgabe zugrunde eine Vorrichtung zum Aufnehmen von mit elektronischen Bauelementen befüllten Gebinden und ein Verfahren zum Überprüfen der Belegung einer derartigen Gebinde-Aufnahmevorrichtung mit eingebrachten Gebinden anzugeben, welche auf einfache Weise die Sicherheit bei der Rüstung von Bestückvorrichtungen und damit die gesamte Prozesssicherheit erhöhen.

Diese Aufgabe wird gelöst durch die Gegenstände der unabhängigen Patentansprüche. Vorteilhafte Ausführungsformen der vorliegenden Erfindung sind in den abhängigen Ansprüchen beschrieben.

Mit dem unabhängigen Anspruch 1 wird eine Vorrichtung zum Aufnehmen von mit elektronischen Bauelementen befüllten Gebinden beschrieben. Die beschriebene Gebinde-Aufnahmevorrichtung weist auf (a) ein Gehäuse, (b) eine Mehrzahl von Aufnahmebereichen, die in dem Gehäuse angeordnet sind, wobei in jeweils einen Aufnahmebereich ein mit elektronischen Bauelementen befülltes Gebinde einbringbar ist, und (c) eine Sende- und Empfangseinrichtung, welche derart eingerichtet ist, dass über einen Datenaustausch mit einem an einem bestimmten Gebinde angebrachten kontaktlosen Übertragungselement derjenige Aufnahmebereich identifizierbar ist, in dem sich das bestimmte Gebinde befindet. Dabei umfasst der Datenaustausch eine Signal-Laufzeitmessung zwischen der Sende- und Empfangseinrichtung und dem kontaktlosen Übertragungselement.

Der beschriebenen Vorrichtung liegt die Erkenntnis zugrunde, dass die Laufzeit eines Signals zwischen der Sende- und Empfangseinrichtung und dem kontaktlosen Übertragungselement zur Positionsbestimmung des Übertragungselements und damit auch zur Positionsbestimmung des entsprechenden Gebindes herangezogen werden kann. Das Signal ist bevorzugt ein elektromagnetisches Funksignal, welches sich entsprechend den Gesetzen der Physik mit Lichtgeschwindigkeit ausbreitet. Dies bedeutet, dass sich das Signal in einer Nanosekunde (=$10^{-9}$s) eine Wegstrecke um ca. 30 cm zurücklegt. So kann beispielsweise bei einer Messung der Signal-Laufzeit mit einer Genauigkeit von 0,1 ns (=$10^{-10}$s) die Position des entsprechenden Gebindes mit einer räumlichen Genauigkeit von 3 cm erkannt werden. In Anbetracht einer typischen Gebindebreite von einigen Zentimetern und der daran angepassten Breite der einzelnen Aufnahmebereichen ist eine derartige Messgenauigkeit ausreichend, um die Position des kontaktlosen Übertragungselements und damit den jeweiligen Aufnahmebereich der gesamten Gebinde-Aufnahmevorrichtung zu erkennen, in welchem Aufnahmebereich sich das entsprechende Gebinde befindet.

Die kontaktlosen Übertragungselemente können beispielsweise Radio Frequency Identification (RFID) Chips sein, die in bekannter Weise als passive RFID-Chips ohne eigene Stromversorgung oder auch als aktive RFID-Chips mit eigener Stromversorgung ausgebildet sein können. Die technischen Details von solchen RFID-Chips und von geeigneten Sende- und Empfangseinrichtungen sind dem Fachmann geläufig und werden deshalb an dieser Stelle nicht weiter erläutert. Entscheidend ist lediglich, dass im Falle der Verwendung von passiven RFID-Chips die Sende- und Empfangseinrichtung zum Messen der Signal-Laufzeit eingerichtet ist. Im Falle der Verwendung von aktiven RFID-Chips, die einen eigenen Prozessor aufweisen, kann die Laufzeitmessung von dem Prozessor und/oder von der Sende- und Empfangseinrichtung durchgeführt werden.

Die Laufzeit kann beispielsweise dadurch erfasst werden, dass ein aktiver RFID-Chip in einem festen regelmäßigen Zeitraster Signale aussendet, die von der Sende- und Empfangseinrichtung aufgenommen werden. Im Falle einer festen Synchronisation der Zeitbasen von RFID-Chip und Sende- und Empfangseinrichtung kann dann allein durch den Zeitpunkt der Detektion eines Signals auf Seiten der Sende- und Empfangseinrichtung die Position des RFID-Chips bestimmt werden. Das gleiche gilt im umgekehrten Fall, bei dem die Sendesignale von der Sende- und Empfangseinrichtung ausgesendet und von einem aktiven RFID-Chip empfangen werden, dessen Zeitbasis ebenfalls mit der Zeitbasis der Sende- und Empfangseinrichtung synchronisiert ist. Die Auswertung der Laufzeit erfolgt dann in einem Prozessor des aktiven RFID-Chip. Das Ergebnis der Auswertung kann dann in geeigneter Weise bevorzugt mittels eines digitalisierten Datensignals an die Sende- und Empfangseinrichtung gesendet werden.

Gemäß einem Ausführungsbeispiel der Erfindung nach Anspruch 2 umfasst der Datenaustausch eine Signal-Laufzeitmessung von der Sende- und Empfangseinrichtung hin zu dem kontaktlosen Übertragungselement und von dem kontaktlosen Übertragungselement hin zu der Sende- und Empfangseinrichtung. Dies bedeutet, dass innerhalb der zu messenden Laufzeit das Signal zwei Übertragungsstrecken zurücklegt. Eine erste Übertragungsstrecke zwischen der Sende- und Empfangseinrichtung und dem kontaktlosen Übertragungselement und eine zweite Übertragungsstrecke zwischen dem kontaktlosen Übertragungselement und der Sende- und Empfangseinrichtung. Selbstverständlich kommt zu dieser doppelten Laufzeit noch eine gewisse Responszeit dazu, welche das kontaktlose Übertragungselement benötigt, um nach dem Empfang eines Anfragesignals von der Sende- und Empfangseinrichtung ein entsprechendes Antwortsignal an die Sende- und Empfangseinrichtung auszusenden. Da eine derartige Responszeit für ein und dasselbe Übertragungselement jedoch stets gleich lang ist, kann die Responsezeit bei der Ermittlung der Signallaufzeit auf einfache Weise herausgerechnet werden.

Gemäß Anspruch 3 sind die Aufnahmebereiche Fächer, die entlang einer Reihe angeordnet sind. Dies hat den Vorteil, dass bereits eine einzige Laufzeitmessung, innerhalb der sich das Signal entlang einer durch diese Reihe definierte Richtung fortpflanzt, genügt, um die Position des eines Übertragungselements bzw. eines Gebindes in der eindimensionalen Reihe eindeutig zu identifizieren.

Die Fächer können zumindest auf einer Seite ein ausreichend große Öffnung aufweisen, so dass jeweils ein Gebinde auf einfache Weise manuell in das Fach eingelegt werden kann.

Gemäß Anspruch 4 weist die Gebinde-Aufnahmevorrichtung zusätzlich eine weitere Sende- und Empfangseinrichtung auf, welche derart eingerichtet ist, dass zusätzlich über einen weiteren Datenaustausch mit dem kontaktlosen Übertragungselement derjenige Aufnahmebereich identifizierbar ist, in dem sich das bestimmte Gebinde befindet.

Die Bereitstellung eines weiteren Datenkanals zwischen dem kontaktlosen Übertragungselement und der weiteren Sende- und Empfangseinrichtung hat den Vorteil, dass der Aufnahmebereich, in dem sich das jeweilige Gebinde befindet, mit einer erhöhten Zuverlässigkeit identifiziert werden kann. Auf diese Weise kann die Prozesssicherheit eines Bestückautomaten weiter verbessert werden, da die Zuordnung zwischen den Gebinden, die sich in verschiedenen Aufnahmebereichen befinden, und einer Bauelement-Zuführvorrichtung, die dem Bestückprozess jeweils einen bestimmten Typ von Bauelement an einer vorgegebenen Abholposition zur Verfügung stellt, auf effektive Weise überprüft werden kann. Sollte die Überprüfung dieser Zuordnung zu einer Fehlermeldung führen, weil beispielsweise versehentlich ein falsches Gebinde in einen bestimmten Aufnahmebereich eingebracht wurde, dann kann der Bestückprozess unterbrochen werden. Auf diese Weise können Fehlbestückungen, die üblicherweise zu einem Verwerfen der entsprechenden bestückten Schaltungsträger führen, auf effektive Weise verhindert werden.

Gemäß Anspruch 5 umfasst der weitere Datenaustausch eine weitere Signal-Laufzeitmessung zwischen der weiteren Sende- und Empfangseinrichtung und dem kontaktlosen Übertragungselement. Dies hat den Vorteil, dass zur Erhöhung der Messgenauigkeit auf einfache Weise zwei gleichwertige, im Prinzip redundante Informationen miteinander kombiniert werden können.

Gemäß Anspruch 6 zeichnet sich die Gebinde-Aufnahmevorrichtung dadurch aus, dass (a) die Sende- und Empfangseinrichtung an einem ersten Ende des Gehäuses angeordnet ist und dass (b) die weitere Sende- und Empfangseinrichtung an einem dem ersten Ende gegenüberliegenden zweiten Ende des Gehäuses angeordnet ist. Dies bedeutet, dass sich sämtliche Aufnahmebereiche zwischen den beiden Sende- und Empfangseinrichtungen befinden. Ein Gebinde kann somit unabhängig von dem jeweiligen Aufnahmebereich, in dem es sich gerade befindet, von beiden Sende- und Empfangseinrichtungen adressiert werden.

Sofern die Aufnahmebereiche zwischen den beiden Sende- und Empfangseinrichtungen entlang einer Reihe angeordnet sind, sind die beiden Laufzeitmessungen zueinander komplementär. Dies beruht auf der einfach einzusehenden Tatsache, dass auch die entsprechenden Übertragungsstrecken eine zueinander komplementäre Länge aufweisen. Sofern sich ein Aufnahmebereich nämlich beispielsweise näher bei der Sende- und Empfangseinrichtung befindet, wird der Abstand zwischen diesem Aufnahmebereich und der weiteren Sende- und Empfangseinrichtung entsprechend größer sein. Im Falle einer exakt linearen Anordnung der beiden Sende- und Empfangseinrichtungen und der dazwischen befindlichen Aufnahmebereiche gilt folgender Zusammenhang:

$$\Delta t1 + \Delta t2 = \Delta s/c$$

Dabei ist $\Delta t1$ die einfache Signal-Laufzeit zwischen einem bestimmten Übertragungselement und der Sende- und Empfangseinrichtung, $\Delta t2$ die einfache Laufzeit zwischen diesem Übertragungselement und der weiteren Sende- und Empfangseinrichtung $\Delta t2$, $\Delta s$ der räumliche Abstand zwischen den beiden Sende- und Empfangseinrichtungen und c die Lichtgeschwindigkeit.

Gemäß Anspruch 7 weist die Gebinde-Aufnahmevorrichtung zusätzlich eine Mehrzahl von Trennelementen auf, wobei (a) einem Aufnahmebereich jeweils zwei Trennelemente zur räumlichen Abgrenzung des Aufnahmebereichs zugeordnet sind, und wobei (b) die Trennelemente aus einem Material bestehen, welches eine Transmission elektromagnetischer Strahlung ermöglicht.

Das Material kann demzufolge jedes nicht abschirmende Material wie beispielsweise Kunststoff sein. Bei der Wahl des für die Trennelemente verwendeten Materials und bei der Wahl der Dicke der Trennelemente sollte beachtet werden, dass die elektromagnetischen Signale abhängig von der Anzahl der vorgesehenen Aufnahmebereiche ggf. eine Vielzahl von Trennelementen zu durchdringen haben. Die Transmission der entsprechenden elektromagnetischen Strahlung durch jedes einzelne Trennelement sollte demzufolge möglichst groß sein.

Gemäß Anspruch 8 sind die Aufnahmebereiche derart geformt, dass die Gebinde mit einer vertikalen Orientierung einstellbar sind. Dies hat den Vorteil, dass die gesamte Gebinde-Aufnahmevorrichtung auch dann in einer kompakten Bauform realisiert werden kann, wenn eine Vielzahl von Aufnahmebereichen vorhanden ist. Die Aufnahmebereiche können dabei ggf. unterschiedliche Breiten aufweisen, so dass die Gebinde entsprechend ihrer Breite in geeignete Aufnahmebereiche eingestellt werden können, ohne dass die Gesamtbreite der Gebinde-Aufnahmevorrichtung unnötig vergrößert wird.

Gemäß Anspruch 9 sind die Aufnahmebereiche derart geformt, dass jeweils ein als Spulenkörper ausgebildetes Gebinde einbringbar ist. Die beschriebene Gebinde-Aufnahmevorrichtung kann somit in Verbindung mit Gebindeformen betrieben werden, die in der Praxis besonders häufig zum Bereitstellen von elektronischen Bauelementen verwendet werden. Spulenkörper werden in diesem Zusammenhang mit sog. Bauelement-Gurten verwendet. Derartige Gurte werden auf den Spulenkörper zum Zwecke einer Platz sparenden Bauelement-Aufbewahrung aufgewickelt und im Laufe einer Bauelement-Bereitstellung wieder abgewickelt. Dabei werden sequentiell elektronische Bauelemente an einer Abholposition bereitgestellt, die sich in sog. Gurttaschen befinden. Um ein unbeabsichtigtes Herausfallen der Bauelemente zu verhindern, kann in bekannter Weise eine Deckfolie vorgesehen sein, die den mit Bauelementen befüllten Gurt bedeckt und die unmittelbar vor der Bauelement-Entnahme durch einen Bestückkopf abgezogen wird.

Die beschriebene laufzeit-basierte Auswertung der Datenkommunikation zwischen der Sende- und Empfangseinrichtung und dem kontaktlosen Übertragungselement kann für verschiedene Gebinde auf quasi kontinuierlicher Weise durchgeführt werden. Dabei werden wiederholt alle in Frage kommenden Übertragungselemente sequentiell abgefragt. Auf diese Weise kann beispielsweise eine kurzzeitige Entnahme eines Gebindes aus einem Aufnahmebereich der Gebinde-Aufnahmevorrichtung erkannt werden. Dies ist beispielsweise bei einem sog. Spleißvorgang erforderlich, bei dem zum Zwecke einer unterbrechungsfreien Bestückung an das Ende eines ersten Bauelement-Gurtes der Anfang eines zweiten Bauelement-Gurtes angekoppelt wird. Bei Einstellen der zweiten Spule mit dem zweiten Gurt kann dann automatisch auf einfache Weise überprüft werden, ob die Bauelemente des zweiten Gurtes auch tatsächlich hinsichtlich ihres Typs mit den Bauelementen des ersten Typs identisch sind.

Mit dem nebengeordneten Anspruch 10 wird ein Zuführsystem zum sequentiellen Bereitstellen von elektronischen Bauelementen für eine Bestückvorrichtung beschrieben. Das beschriebene Zuführsystem weist auf (a) eine Vorrichtung des oben beschriebenen Typs zum Aufnehmen von mit elektronischen Bauelementen befüllten Gebinden und (b) eine Mehrzahl von Zuführvorrichtungen zum sequentiellen Zuführen von in einem Gebinde aufbewahrten Bauelementen, wobei jeweils einer Zuführvorrichtung ein Aufnahmebereich zugeordnet ist.

Dem beschriebenen Zuführsystem liegt die Erkenntnis zugrunde, dass sich mit der oben beschriebenen Gebinde-Aufnahmevorrichtung, mit der auf zuverlässige Weise die in den einzelnen Aufnahmebereichen vorhandenen Gebinde identifiziert werden können, auf einfache Weise eine feste Zuordnung zwischen den einzelnen Zuführvorrichtungen und den jeweiligen Gebinden herstellen lässt. So kann beispielsweise bei dem Einlegen eines Gebindes, welches nicht die vorgesehenen Bauelemente enthält, eine Fehlermeldung ausgegeben werden und/oder der Bestückprozess einer Bestückvorrichtung angehalten werden.

Es kann ferner vorkommen, dass die Bauelemente bzgl. ihres Typs zwar korrekt zugeführt werden, die entsprechenden Bauelement-Gurte jedoch über Kreuz zu den entsprechenden Zuführvorrichtungen verlaufen, da zwei Gebinde innerhalb der Gebinde-Aufnahmevorrichtung vertauscht wurden. Diese Art der Belegung der Aufnahmevorrichtung muss zwar nicht zwingend zu einer falschen Bestückung führen. Die Gefahr einer fehlerhaften Bauelement-Zuführung ist jedoch signifikant erhöht, da bei einem Überkreuzen der Bauelement-Gurte eine Beschädigung der Gurte nicht unwahrscheinlich ist. Durch die Verwendung der oben beschriebenen Gebinde-Aufnahmevorrichtung kann jedoch eine derartige schlampige Aufnahme von Gebinden zuverlässig erkannt werden, da in diesem Fall eine voreingestellte Zuordnung zwischen den Zuführvorrichtungen und den Aufnahmebereichen verletzt wird. Durch ein entsprechendes Alarm- bzw. Fehlersignal können derartige Fehlbelegungen der Aufnahmevorrichtung zuverlässig verhindert und die Prozesssicherheit der Bauelement-Zuführung entsprechend erhöht werden.

Gemäß Anspruch 11 weist das Zuführsystem zusätzlich ein Führungselement auf, welches sich zumindest teilweise von einer Zuführvorrichtung zu einem der Zuführvorrichtung zugeordneten Aufnahmebereich erstreckt. Das Führungselement kann somit auf mechanische Art und Weise eine feste Zuordnung zwischen einer Zuführvorrichtung und dem entsprechendem Aufnahmebereich der Gebinde-Aufnahmevorrichtung sicherstellen. Dadurch ist neben der oben beschriebenen Kontrolle der Gebindezuordnung mittels einer laufzeitbasierten Auswertung der Kommunikation zwischen der Sende- und Empfangseinrichtung und dem kontaktlosen Übertragungselement eine zusätzliche Sicherheit für eine korrekte Bauelement-Zuführung und damit für eine hohe Prozesssicherheit des gesamten Bestückungsvorgangs gegeben.

Gemäß Anspruch 12 weist das Führungselement einen Kanal auf, in dem ein von einem Gebinde abgewickelter und der Zuführvorrichtung zuzuführender Bauelement-Gurt führbar ist.

Der Kanal stellt somit einen Leitkanal für einen von einem Gebinde abgewickelten Bauelement-Gurt dar, so dass sichergestellt wird, dass der abgewickelte Gurt auch tatsächlich zu der entsprechenden Zuführvorrichtung transferiert wird. Ein versehentliches oder auch ein beabsichtigtes Überkreuzen von verschiedenen Bauelement-Gurten kann somit auf einfache und flexible Weise verhindert werden.

Der Kanal kann ein entlang einer Umlaufrichtung vollständig geschlossener Hohlkörper sein, der für den Bauelement-Gurt eine Art Tunnel darstellt. Ebenso kann der Kanal jedoch auch ein offenes Gebilde sein, welches eine zuverlässige Führung eines Bauelement-Gurts ermöglicht.

Gemäß Anspruch 13 weist das Zuführsystem zusätzlich eine Antenne auf, welche relativ zu dem Führungselement derart angeordnet ist, dass ein in dem Bauelement-Gurt befindlicher Datenträger auslesbar ist. Dies hat den Vorteil, dass Informationen über die in dem Bauelement-Gurt enthaltenen elektronischen Bauelemente auf einfach und sichere Weise ausgelesen werden können. Zu diesem Zweck kann die Antenne mit einer entsprechenden Leseeinrichtung gekoppelt sein, die diese bauelementbezogenen Daten an eine zentrale Steuereinheit eines Bestückautomaten übermittelt. Selbstverständlich kann die Leseeinrichtung auch in einer zentralen Steuereinheit integriert sein.

Der Datenträger kann in einem Endbereich des Bauelement-Gurtes angeordnet sein. Eine Erfassung dieses Datenträgers mit der Antenne kann beispielsweise eine Bedienperson anweisen, rechtzeitig einen weiteren Gurt anzukoppeln, so dass die in erforderlichen Bauelemente nicht ausgehen und eine unterbrechungsfreie Bereitstellung von Bauelementen und damit eine quasi-kontinuierliche Bestückung möglich ist. Ebenso kann der Datenträger auch an anderen Stellen entlang des Bauelement-Gurtes angeordnet sein und beispielsweise Informationen über die noch zur Verfügung stehenden Bauelemente enthalten. Auf diese Weise kann einer Bedienperson bereits frühzeitig angezeigt werden, wann ein Ankoppeln eines weiteren Bauelement-Gurtes erforderlich sein wird.

Die Antenne kann eine ringartige Form aufweisen und das Führungselement umgeben. Auf diese Weise kann eine hohe Übertragungssicherheit zwischen einem in dem Gurt befindlichen Datenträger und einer mit der Antenne gekoppelten Leseeinrichtung gewährleistet werden.

Mit dem nebengeordneten Anspruch 14 wird eine Bestückvorrichtung zum Bestücken von zum Bestücken von Leiterplatten mit elektronischen Bauelementen beschrieben. Die beschriebene Bestückvorrichtung weist ein Zuführsystem des oben beschriebenen Typs auf.

Der beschriebenen Bestückvorrichtung liegt die Erkenntnis zugrunde, dass durch die Verwendung des oben beschriebenen Zuführsystems, welches die weiter oben beschriebene Gebinde-Aufnahmevorrichtung aufweist, eine verbesserte Prozesssicherheit eines Bestückautomaten insbesondere bezüglich der Zuführung des korrekten Bauelement-Typs an die entsprechende Bauelement-Zuführvorrichtung gewährleistet kann. Innerhalb der Bestückvorrichtung kann somit auf einfach Weise festgestellt werden, ob sich in der Gebinde-Aufnahmevorrichtung jedes Gebinde mit den entsprechenden Bauelementen auch tatsächlich in dem jeweils vorgesehenen Aufnahmebereich befindet.

Die korrekte Zuordnung zwischen Gebinde und Bauelement-Zuführvorrichtung kann dabei mittels einer quasi kontinuierlichen Datenkommunikation überprüft werden. Damit können Manipulationen bei der Belegung der Aufnahmebereiche unverzüglich erkannt werden.

Mit dem nebengeordneten Anspruch 15 wird ein Verfahren zum Überprüfen der Belegung einer Gebinde-Aufnahmevorrichtung mit in die Aufnahmebereiche eingebrachten Gebinden beschrieben, welche Gebinde mit elektronischen Bauelementen befüllt sind. Das beschriebene das Verfahren weist folgende Schritte auf: (a) Übertragen eines elektromagnetischen Signals zwischen der Sende- und Empfangseinrichtung und der einem an einem bestimmten Gebinde angebrachten kontaktlosen Übertragungselement, (b) Messen der Signal-Laufzeit zwischen der Sende- und Empfangseinrichtung und dem kontaktlosen Übertragungselement und (c) Identifizieren desjenigen Aufnahmebereiches, in dem sich das bestimmte Gebinde befindet, unter Berücksichtigung der ermittelten Signal-Laufzeit.

Dem genannten Verfahren liegt die Erkenntnis zugrunde, dass die Laufzeit eines Signals zwischen der Sende- und Empfangseinrichtung und dem kontaktlosen Übertragungselement zur Positionsbestimmung des Übertragungselements und damit auch zur Positionsbestimmung des entsprechenden Gebindes herangezogen werden kann. Das Signal ist bevorzugt ein elektromagnetisches Funksignal, welches sich entsprechend den Gesetzen der Physik mit Lichtgeschwindigkeit ausbreitet.

Die Laufzeit kann beispielsweise dadurch erfasst werden, dass die Sende- und Empfangseinrichtung ein Anfragesignal zu einem als RFID-Chip ausgebildeten Übertragungselement aussendet. Nach einer gewissen Responsezeit wird von dem RFID-Chip ein Antwortsignal ausgesendet, dass von der Sende- und Empfangseinrichtung empfangen wird. Die Zeitspanne zwischen Aussenden des Anfragesignals und Empfang des Antwortsignals wird gemessen, so dass unter der Vorraussetzung, dass die Responsezeit genau bekannt ist, auf einfache Weise die doppelte Signal-Laufzeit und damit die räumliche Position des RFID-Chips bzw. des entsprechenden Gebindes relativ zu der Sende- und Empfangseinrichtung bestimmt werden kann.

Weitere Vorteile und Merkmale der vorliegenden Erfindung ergeben sich aus der folgenden beispielhaften Beschreibung derzeit bevorzugter Ausführungsformen. Die einzelnen Figuren der Zeichnung dieser Anmeldung sind lediglich als schematisch und als nicht maßstabsgetreu anzusehen.

Figur 1 zeigt ein Bestücksystem, welches zwei entlang einer Leiterplatten-Transportstrecke angeordnete Bestückautomaten aufweist, die mit einer Gebinde-Aufnahmevorrichtung ausgestattet sind, welche eine automatische Positionsbestimmung der eingebrachten Gebinde ermöglicht.

Figur 2 zeigt eine perspektivische Ansicht eines als Spulenkörper ausgebildeten Gebindes, auf dem ein mit elektronischen Bauelementen befüllter Bauelement-Gurt aufgewickelt ist.

Figur 3 zeigt eine Gebinde-Aufnahmevorrichtung, welche eine Mehrzahl von Fächern aufweist, in die als Spulenkörper ausgebildete Gebinde einbringbar sind.

Figur 4 zeigt ein Bauelement-Zuführsystem, welches eine Zuführvorrichtung und eine Gebinde-Aufnahmevorrichtung aufweist, wobei zumindest eine Zuführvorrichtung mit einem Aufnahmebereich der Gebinde-Aufnahmevorrichtung über einen Gurtleitkanal mechanisch gekoppelt ist.

An dieser Stelle bleibt anzumerken, dass sich in der Zeichnung die Bezugszeichen von gleichen oder von einander entsprechenden Komponenten lediglich in ihrer ersten Ziffer und/oder durch einen angehängten Buchstaben unterscheiden.

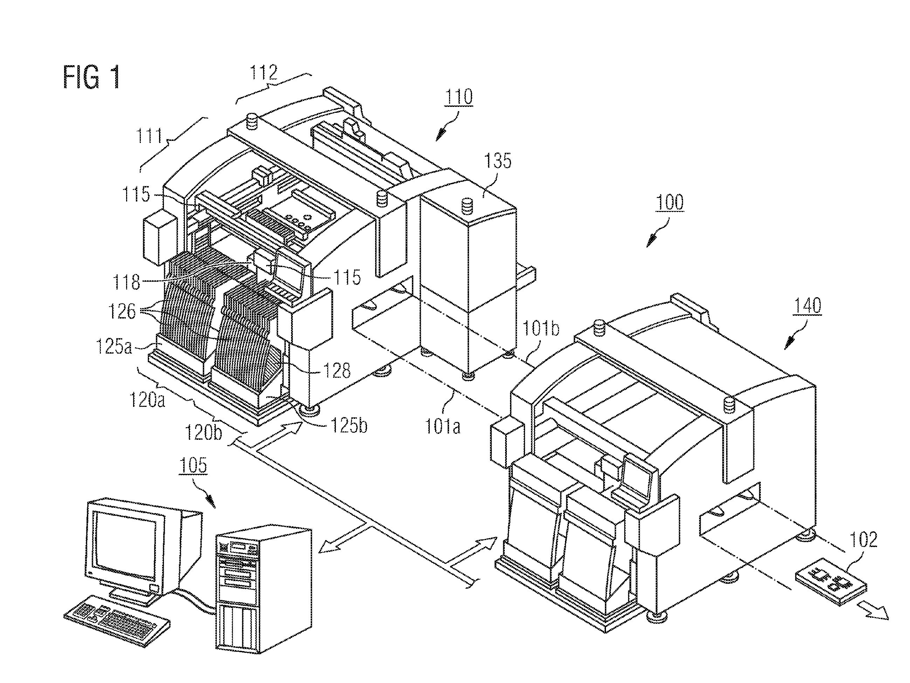

Figur 1 zeigt ein Bestücksystem 100, welches einen ersten Bestückautomaten 110 und einen zweiten Bestückautomaten 140 aufweist. Die beiden Bestückautomaten 110, 140 sind mittels einer Transportstrecke 101 miteinander verbunden. Die Transportstrecke 101 dient der Zuführung bzw. der Abführung von Leiterplatten 102, die in jeweils einem Bestückbereich der Bestückautomaten 110 und 140 mit elektronischen Bauelementen bestückt werden.

Gemäß dem hier dargestellten Ausführungsbeispiel sind die beiden Bestückautomaten 110, 140 sog. Doppelspur Bestückautomaten 110, 140, die jeweils eine vordere Plattform 111 und eine hintere Plattform 112 aufweisen. Aus Gründen der Übersichtlichkeit ist lediglich der erste Bestückautomat 110 so detailliert dargestellt, dass die nachfolgend beschriebenen Ausführungsbeispiele der Erfindung deutlich zu erkennen sind.

Entsprechend des zweiteiligen Aufbaus der beiden Bestückautomaten 110, 140 weist die Leiterplatten-Transportstrecke 101 zwei Transportspuren, eine erste Transportspur 101a und eine zweite Transportspur 101b auf, welche jeweils einer Plattform 111 bzw. 112 zugeordnet sind. Der gesamte Bestückablauf wird von einer zentralen Steuerungseinrichtung 105 gesteuert, die über eine entsprechende Datenverbindung mit den beiden Bestückautomaten 110, 140 verbunden ist.

Wie aus Figur 1 ersichtlich, weist der Bestückautomat 110 ein Flächen-Positioniersystem 115 auf, mit dem ein Bestückkopf 116 innerhalb einer horizontalen xy-Ebene bewegt werden kann. Der Bestückkopf ist der vorderen Plattform 111 des Bestückautomaten 110 zugeordnet. Mittels des Bestückkopfes 116 können in bekannter Weise Bauelemente von zwei Bauelement-Zuführsystemen 120a, 120b abgeholt, in einen Bestückbereich des Bestückautomaten 110 transportiert und auf einer Leiterplatte aufgesetzt werden, die sich gerade in dem Bestückbereich befindet. Um eine präzise Bestückposition zu gewährleisten, ist ferner eine Bauelement-Kamera 118 vorgesehen, mittels welcher in bekannter Weise die Positionen der von dem Bestückkopf 116 aufgenommenen Bauelemente mit hoher Genauigkeit erfasst werden können.

Der Bestückautomat 110 umfasst ferner ein nicht dargestelltes weiteres Flächen-Positioniersystem, mit dem ein weiterer Bestückkopf positioniert werden kann. Der weitere Bestückkopf ist der hinteren Plattform des Bestückautomaten 110 zugeordnet.

Das Bauelement-Zuführsystem 120a bzw. 120b weist jeweils eine Gebinde-Aufnahmevorrichtung 125a bzw. 125b auf. Die Gebinde-Aufnahmevorrichtungen 125a und 125b sind in eine Mehrzahl von einzelnen fächerartigen Aufnahmebereichen 126 aufgeteilt. In die Fächer 126 kann jeweils ein als Spulenkörper ausgebildetes Gebinde eingestellt werden, auf dem in bekannter Weise ein Bauelement-Gurt aufgewickelt ist. In dem aufgewickelten Gurt sind elektronische Bauelemente aufbewahrt.

Die Gebinde-Aufnahmevorrichtungen 125a und 125b sind jeweils mit einer Sende- und Empfangseinrichtung 128 ausgestattet, welche mit RFID-Chips kommunizieren können, die an den Spulenkörpern angebracht sind. Durch eine Bestimmung der Laufzeit von Datensignalen, die zwischen der Sende- und Empfangseinrichtung 128 und einem RFID-Chip, welcher einem bestimmten Gebinde zugeordnet ist, übertragen werden, kann die Position des betreffenden RFID-Chips innerhalb der Gebinde-Aufnahmevorrichtung 125a bzw. 125b bestimmt werden. Auf diese Weise kann automatisch erkannt werden, in welchem Fach 128 sich ein bestimmtes Gebinde befindet.

Wie ferner aus Figur 1 ersichtlich, umfasst der Bestückautomat 110 ein Magazin-Zuführsystem 135, mit dem in Flächenmagazinen aufbewahrte Bauelemente einem in der hinteren Plattform Bestückprozess zugeführt werden.

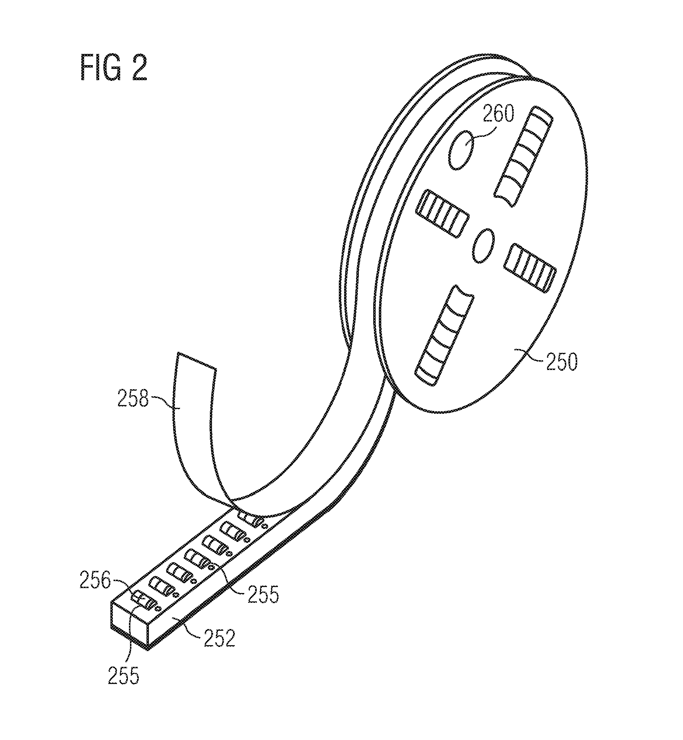

Figur 2 zeigt eine perspektivische Ansicht eines Gebindes 250, welches als Spulenkörper 250 ausgebildet ist. Auf dem Spulenkörper 250 ist ein Bauelement-Gurt 252 aufgewickelt, welcher eine Vielzahl von Ausnehmungen 255 aufweist. Die Ausnehmungen 255 dienen der Aufnahme von jeweils einem elektronischen Bauelement 256. Der Bauelement-Gurt 252 wird in bekannter Weise mittels einer Bauelement-Zuführvorrichtung hin zu einer Bauelement-Aufnahmeposition transportiert, so dass die Bauelemente 256 sequentiell von einem Bestückkopf entnommen werden können. Um ein unbeabsichtigtes Herausfallen der Bauelemente zu verhindern, ist zusätzlich eine Abdeckfolie 258 vorgesehen, welche erst kurz vor der Aufnahmeposition mittels eines geeigneten Abzugsmechanismus von dem Gurt 252 entfernt wird.

An dem Spulenkörper 250 ist ein als RFID-Chip ausgebildetes kontaktloses Übertragungselement 260 angebracht, in dem bauelement-bezogene Daten der Bauelemente 256 gespeichert sein können. Die Position des RFID-Chips 260 innerhalb der in Figur 1 dargestellten Gebinde-Aufnahmevorrichtung 125a bzw. 125b kann mittels einer Signal-Laufzeitmessung der Datensignale ermittelt werden, die zwischen dem RFID-Chip 260 und einer geeigneten Sende- und Empfangseinrichtung transferiert werden.

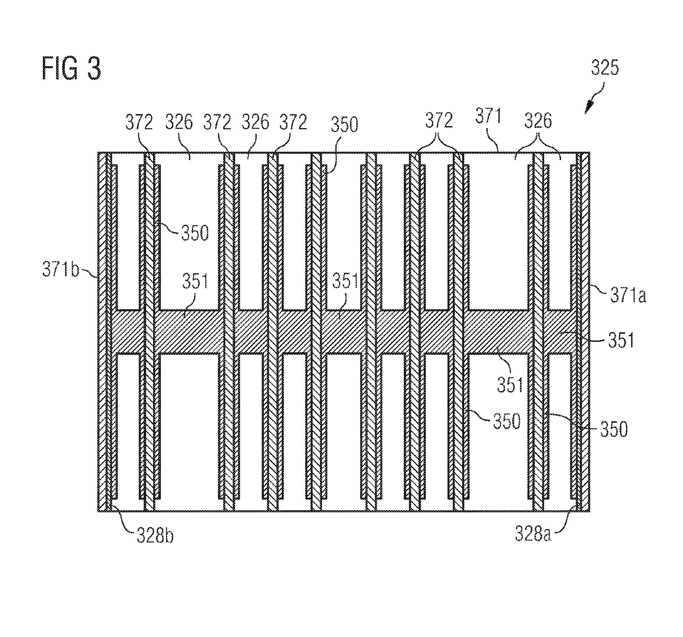

Figur 3 zeigt eine Gebinde-Aufnahmevorrichtung 325, welche ein als Container ausgebildetes Gehäuse 371 aufweist. In dem Gehäuse 371 sind eine Mehrzahl Trennelementen 372 angeordnet, welche den gesamten Container 371 in eine Mehrzahl von fächerartigen Aufnahmebereichen 326 unterteilt. In den Fächern 326 befindet sich jeweils ein als Spulenkörper ausgebildetes Gebinde 350. Aus Gründen der Übersichtlichkeit sind die entsprechenden Bauelement-Gurte, die auf jeweils einer Achse 351 eines Spulenkörpers 350 aufgewickelt sind, nicht dargestellt.

An einem ersten Ende 371a des Gehäuses 371 befindet sich eine erste Sende- und Empfangseinrichtung 328a. An einem zweiten Ende 371b befindet sich eine zweite Sende- und Empfangseinrichtung 328b. Die beiden Sende- und Empfangseinrichtungen 328a und 328b sind derart eingerichtet, dass sie mit in Figur 3 nicht dargestellten RFID-Chips, die an den Spulenkörpern 350 angebracht sind, kommunizieren können. Dabei kann jeweils die Signal-Laufzeit zwischen einem RFID-Chip und den beiden Sende- und Empfangseinrichtungen 328a und 328b gemessen werden. Aufgrund der linearen Anordnung der ersten Sende- und Empfangseinrichtung 328a, der Fächer 326 und der zweiten Sende- und Empfangseinrichtung 328b können die beiden Laufzeitmessungen dazu verwendet werden, das jeweilige Aufnahmefach 326 zu identifizieren, in dem sich ein bestimmter RFID-Chip bzw. das entsprechende Gebinde 371 befindet.

Obwohl die beiden Signal-Laufzeitmessungen zwischen (a) der ersten Sende- und Empfangseinrichtung 328a und dem RFID-Chip und (b) der zweiten Sende- und Empfangseinrichtung 328b und dem RFID-Chip redundante bzw. zueinander komplementäre Informationen liefern, können die beiden entsprechenden Messergebnisse zum Zwecke einer verbesserten Messgenauigkeit miteinander kombiniert werden. Somit kann der Aufnahmebereich 326, in dem sich das jeweilige Gebinde 350 befindet, mit einer erhöhten Zuverlässigkeit identifiziert werden. Dies trägt zu einer Erhöhung der Prozesssicherheit eines Bestückautomaten bei, da die Zuordnung zwischen den Gebinden 350 und verschiedenen in Figur 3 nicht dargestellten Bauelement-Zuführvorrichtungen, die dem Bestückprozess jeweils einen bestimmten Typ von Bauelement zur Verfügung stellen, auf effektive Weise überprüft werden kann.

Es wird darauf hingewiesen, dass die Trennelemente 372 aus einem Material bestehen, welches eine besonders gute Transmission von elektromagnetischer Strahlung ermöglicht. Auf diese Weise kann sichergestellt werden, dass die Datenkommunikation zwischen (a) der ersten Sende- und Empfangseinrichtung 328a und dem RFID-Chip und (b) der zweiten Sende- und Empfangseinrichtung 328b und dem RFID-Chip weitgehend störungsfrei erfolgen kann, ohne das zur Realisierung der beschrieben Positionsbestimmung bzw. - überwachung elektromagnetische Signale mit außergewöhnlich hoher Intensität verwendet werden müssen.

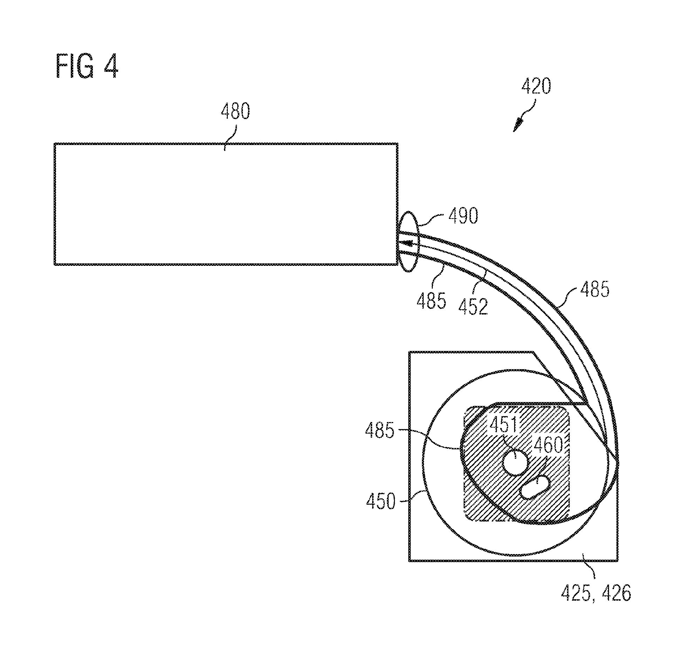

Figur 4 zeigt in einer Querschnittsdarstellung ein Bauelement-Zuführsystem 420, welches eine Gebinde-Aufnahmevorrichtung 425 und eine Bauelement-Zuführvorrichtung 480 aufweist.

In einem Aufnahmebereich 426 der Gebinde-Aufnahmevorrichtung befindet 425 sich ein Spulenkörper 450. Der Spulenkörper 450 weist eine Achse 451 auf, auf die ein mit elektronischen Bauelementen befüllter Bauelement-Gurt 452 aufgewickelt ist. An einer seitlichen Wand des Spulenkörpers 450 ist ein als RFID-Chip ausgebildetes kontaktloses Übertragungselement 460 angebracht. Der RFID-Chip kann, wie oben bereits erläutert, mit einer in Figur 4 nicht dargestellten Sende- und Empfangseinrichtung kommunizieren, wobei die Laufzeit der entsprechenden Datensignale für eine Positionsbestimmung des Gebindes 450 innerhalb der Gebinde Aufnahmevorrichtung 425 herangezogen wird. Auf diese Weise kann die Zuordnung zwischen einem Gebinde 450 und einer Bauelement-Zuführvorrichtung 480 auf effektive Weise überprüft werden.

Gemäß dem hier dargestellten Ausführungsbeispiel wird die Zuordnung zwischen dem Aufnahmebereich 426 und der Bauelement-Zuführvorrichtung 480 ferner auf mechanische Weise durch ein Führungselement 485 gewährleistet. Das Führungselement 485 ist derart ausgeformt, dass der Transportweg des Bauelement-Gurts 452 von dem Gebinde 450 hin zu der Bauelement-Zuführvorrichtung 480 fest vorgegeben ist. Das Führungselement stellt somit einen mechanischen Gurtleitkanal 485 dar, welcher sicherstellt, dass der Bauelement-Gurts 452 nicht einer falschen Bauelement-Zuführvorrichtung 480 zugeführt wird.

Gemäß dem hier dargestellten Ausführungsbeispiel weist das Bauelement-Zuführsystem 420 zusätzlich eine Antenne 490 auf. Die Antenne 490 weist eine Ringform auf, welche den Gurtleitkanal 485 umgibt. Auf diese Weise kann mittels der Antenne 490 ein nicht dargestellter Datenträger ausgelesen werden, in dem beispielsweise Informationen über den Typ und/oder die Anzahl der in dem Bauelement-Gurt 452 enthaltenen elektronischen Bauelemente abgespeichert sind. Zu diesem Zweck kann die Antenne 490 mit einer entsprechenden Leseeinrichtung gekoppelt sein, die diese bauelementbezogenen Daten an eine zentrale Steuereinheit eines Bestückautomaten übermittelt.

Der Datenträger kann in einem Endbereich des Bauelement-Gurtes 452 angeordnet sein. Eine Erfassung dieses Datenträgers mittels der Antenne 490 kann beispielsweise eine Bedienperson anweisen, rechtzeitig einen weiteren Gurt 452 anzukoppeln, so dass die erforderlichen Bauelemente nicht ausgehen und eine unterbrechungsfreie Bereitstellung von Bauelementen und damit eine quasi-kontinuierliche Bestückung möglich ist.

Die Verwendung eines Gurtleitkanals 485 hat den Vorteil, dass durch ein geeignetes Einfädeln des Gurtes 452 in den Gurtleitkanal 485 eine zusätzliche lückenlose Sicherstellung der Zuordnung zwischen (a) einem Gebinde 450 bzw. den darin befindlichen Bauelementen und (b) einer Bauelement-Zuführvorrichtung 480 bzw. der entsprechenden Zuführspur gewährleistet werden kann. Der Gurtleitkanal 485 ist dabei derart ausgebildet, dass er sich nicht zur Seite weg bewegen kann. Ferner kann der Gurtleitkanal 485 an seinem unteren Ende derart ausgebildet sein, dass er an der Gebinde-Aufnahmevorrichtung 425 eingehängt und damit lösbar fixiert werden kann.

Durch die Verwendung des Gurtleitkanals 485 wird somit eine zusätzliche Sicherheit bezüglich der Rüstung eines Bestückautomaten geschaffen. Auf diese Weise wird eine weitere Rüstkontrolle, die beispielsweise ein manuelles Einlesen (a) eines Barcodes an einem Gebinde 450 und (b) eines Barcodes an einer Zuführvorrichtung 480 bzw. einer Zuführspuren umfasst, nicht mehr erforderlich ist.

Die Kommunikation zwischen einer Sende- und Empfangseinrichtung und einem RFID-Chip 460 schafft zudem die Möglichkeit, dass insbesondere bauelementbezogene Daten aktualisiert werden können. Eine Manipulation der Zuordnung zwischen Gebinde 450 und Bauelement-Zuführvorrichtung 480 kann somit sowohl durch den Gurtleitkanal 485 auf mechanische Art und Weise als auch durch die beschriebene RFID-Überwachung in der Gebinde-Aufnahmevorrichtung 425 auf elektronische Weise ausgeschlossen werden, da jedes Herausnehmen eines Gebindes 450 sofort registriert werden kann.

Da mit dem Bauelement-Zuführsystem 420 auf einfache Weise eine lückenlose Erfassung der Gebinde 450 in der Gebinde-Aufnahmevorrichtung 425 durchgeführt werden kann, kann auch der Zeitpunkt eines Spleißvorgangs protokolliert werden, bei dem an das Ende eines ersten Bauelement-Gurtes 452 ein Anfangsstück eines zweiten Bauelement-Gurtes 452 mechanisch angebunden wird, so dass eine kontinuierliche Bauelementzuführung gewährleistet werden kann. Dies kann beispielsweise dadurch erfolgen, dass mit der Entnahme eines Gebindes 450 der entsprechende RFID-Chip 460 nicht mehr erkannt werden kann. Mit dem Einlegen eines neuen Gebindes 450 wird dann eine neuer RFID-Chip 460 erkannt, in dem Informationen über das neue Gebinde 460 abgespeichert sind.

Es wird darauf hingewiesen, dass die hier beschriebenen Ausführungsformen lediglich eine beschränkte Auswahl an möglichen Ausführungsvarianten der Erfindung darstellen. So ist es möglich, die Merkmale einzelner Ausführungsformen in geeigneter Weise miteinander zu kombinieren, so dass für den Fachmann mit den hier expliziten Ausführungsvarianten eine Vielzahl von verschiedenen Ausführungsformen als offensichtlich offenbart anzusehen sind.

Bezugszeichenliste

| | |
|---|---|
| 100 | Bestücksystem |
| 101 | Transportstrecke |
| 101a | erste Transportspur |
| 101b | zweite Transportspur |
| 102 | Leiterplatte |
| 105 | zentrale Steuerungseinrichtung |
| 110 | Bestückautomat |
| 111 | vordere Plattform |
| 112 | hintere Plattform |
| 115 | Flächen-Positioniersystem |
| 116 | Bestückkopf |
| 118 | Bauelement-Kamera |
| 120a | Bauelement-Zuführsystem |
| 120b | Bauelement-Zuführsystem |
| 125a | Gebinde-Aufnahmevorrichtung |
| 125b | Gebinde-Aufnahmevorrichtung |
| 126 | Aufnahmebereiche / Fächer |
| 128 | Sende- und Empfangseinrichtung |
| 135 | Magazin-Zuführsystem |
| 140 | Bestückautomat |
| 250 | Gebinde / Spulenkörper |
| 252 | Bauelement-Gurt |
| 255 | Ausnehmungen / Bauelement-Taschen |
| 256 | Bauelemente |
| 258 | Abdeckfolie |
| 260 | kontaktloses Übertragungselement / RFID-Chip |
| 325 | Gebinde-Aufnahmevorrichtung |
| 328a | erste Sende- und Empfangseinrichtung |
| 328b | zweite Sende- und Empfangseinrichtung |
| 350 | Gebinde / Spulenkörper |
| 351 | Achse des Spulenkörpers |
| 326 | Aufnahmebereiche / Fächer |
| 371 | Gehäuse / Chassis / Gurtcontainer |
| 371a | erstes Ende des Gehäuses |
| 371b | zweites Ende des Gehäuses |
| 372 | Trennelemente |
| 420 | Bauelement-Zuführsystem |
| 425 | Gebinde-Aufnahmevorrichtung |
| 426 | Aufnahmebereich / Fach |
| 450 | Gebinde / Spulenkörper |
| 451 | Achse des Spulenkörpers |
| 452 | Bauelement-Gurt |
| 460 | kontaktloses Übertragungselement / RFID-Chip |
| 480 | Bauelement-Zuführvorrichtung |
| 485 | Führungselement / Gurtleitkanal |
| 490 | Antenne |

**Patentansprüche**

1. Vorrichtung zum Aufnehmen von mit elektronischen Bauelementen (256) befüllten Gebinden (250, 350, 450), die Vorrichtung aufweisend

   • ein Gehäuse (371),
   • eine Mehrzahl von Aufnahmebereichen (126, 326, 426), die in dem Gehäuse (371) angeordnet sind, wobei in jeweils einen Aufnahmebereich (126, 326, 426) ein mit elektronischen Bauelementen (256) befülltes Gebinde (250, 350, 450) einbringbar ist, und
   • eine Sende- und Empfangseinrichtung (128, 328a), welche derart eingerichtet ist, dass über einen Datenaustausch mit einem an einem bestimmten Gebinde (250, 350, 450) angebrachten kontaktlosen Übertragungselement (260, 460) derjenige Aufnahmebereich (126, 326, 426) identifizierbar ist, in dem sich das bestimmte Gebinde (250, 350, 450) befindet,

   wobei
   der Datenaustausch eine Signal-Laufzeitmessung zwischen der Sende- und Empfangseinrichtung (128, 328a) und dem kontaktlosen Übertragungselement (260, 460) umfasst.

2. Vorrichtung nach Anspruch 1, wobei der Datenaustausch eine Signal-Laufzeitmessung von der Sende- und Empfangseinrichtung (128, 328a) hin zu dem kontaktlosen Übertragungselement (260, 460) und
von dem kontaktlosen Übertragungselement (260, 460) hin zu der Sende- und Empfangseinrichtung (128, 328a) umfasst.

3. Vorrichtung nach einem der Ansprüche 1 bis 2, wobei
die Aufnahmebereiche Fächer (126, 326, 426) sind, die entlang einer Reihe angeordnet sind.

4. Vorrichtung nach einem der Ansprüche 1 bis 3, zusätzlich aufweisend

   • eine weitere Sende- und Empfangseinrichtung (328b), welche derart eingerichtet ist, dass zusätzlich über einen weiteren Datenaustausch mit dem kontaktlosen Übertragungselement (260, 460) derjenige Aufnahmebereich (126, 326, 426) identifizierbar ist, in dem sich das bestimmte Gebinde (250, 350, 450) befindet.

5. Vorrichtung nach Anspruch 4, wobei
der weitere Datenaustausch eine weitere Signal-Laufzeitmessung zwischen der weiteren Sende- und Empfangseinrichtung (328b) und dem kontaktlosen Übertragungselement (260, 460) umfasst.

6. Vorrichtung nach einem der Ansprüche 4 bis 5, wobei
die Sende- und Empfangseinrichtung (328a) an einem ersten Ende (371a) des Gehäuses (371) angeordnet ist und
die weitere Sende- und Empfangseinrichtung (328b) an einem dem ersten Ende (371a) gegenüberliegenden zweiten Ende (371b) des Gehäuses (371) angeordnet ist.

7. Vorrichtung nach einem der Ansprüche 1 bis 6, zusätzlich aufweisend

   • eine Mehrzahl von Trennelementen (372), wobei einem Aufnahmebereich (126, 326, 426) jeweils zwei Trennelemente (372) zur räumlichen Abgrenzung des Aufnahmebereichs (126, 326, 426) zugeordnet sind, und wobei die Trennelemente (372) aus einem Material bestehen, welches eine Transmission elektromagnetischer Strahlung ermöglicht.

8. Vorrichtung nach einem der Ansprüche 1 bis 7, wobei
die Aufnahmebereiche (126, 326, 426) derart geformt sind, dass die Gebinde (250, 350, 450) mit einer vertikalen Orientierung einstellbar sind.

9. Vorrichtung nach einem der Ansprüche 1 bis 8, wobei
die Aufnahmebereiche (126, 326, 426) derart geformt sind, dass jeweils ein als Spulenkörper ausgebildetes Gebinde (250, 350, 450) einbringbar ist.

10. Zuführsystem zum sequentiellen Bereitstellen von elektronischen Bauelementen (256) für eine Bestückvorrichtung (110, 140), das Zuführsystem (420) aufweisend

    • eine Vorrichtung (125a, 125b, 325) nach einem der Ansprüche 1 bis 9 zum Aufnehmen von mit elektronischen Bauelementen (256) befüllten Gebinden (250, 350, 450) und
    • eine Mehrzahl von Zuführvorrichtungen (480) zum sequentiellen Zuführen von in einem Gebinde (250, 350, 450) aufbewahrten Bauelementen (256), wobei jeweils einer Zuführvorrichtung ein Aufnahmebereich (126, 326, 426) zugeordnet ist.

11. Zuführsystem nach Anspruch 10, zusätzlich aufweisend

    • ein Führungselement (485), welches sich zumindest teilweise von einer Zuführvorrichtung (480) zu einem der Zuführvorrichtung (480) zugeordneten Aufnahmebereich (126, 326, 426) erstreckt.

12. Zuführsystem nach Anspruch 11, wobei
das Führungselement (485) einen Kanal aufweist, in dem ein von einem Gebinde (250, 350, 450) abgewickelter und der Zuführvorrichtung zuzuführender Bauelement-Gurt (452) führbar ist.

13. Zuführsystem nach Anspruch 12, zusätzlich aufweisend

    • eine Antenne (490), welche relativ zu dem Führungselement (485) derart angeordnet ist, dass ein in dem Bauelement-Gurt (452) befindlicher Datenträger auslesbar ist.

14. Bestückvorrichtung zum Bestücken von zum Bestücken von Leiterplatten (102) mit elektronischen Bauelementen (256), die Bestückvorrichtung (110, 140) aufweisend

    • ein Zuführsystem (120a, 120b, 420) nach einem der Ansprüche 11 bis 13.

15. Verfahren zum Überprüfen der Belegung einer Vorrichtung (125a, 125b, 325) nach einem der Ansprüche 1 bis 9 mit in die Aufnahmebereiche (126, 326, 426) eingebrachten Gebinden (250, 350, 450), welche mit elektronischen Bauelementen (256) befüllt sind, das Verfahren aufweisend

    • Übertragen eines elektromagnetischen Signals zwischen der Sende- und Empfangseinrichtung (128, 328a) und der einem an einem bestimmten Gebinde (250, 350, 450) angebrachten kontaktlosen Übertragungselement (260, 460),

• Messen der Signal-Laufzeit zwischen der Sende- und Empfangseinrichtung (128, 328a) und dem kontaktlosen Übertragungselement (260, 460) und

• Identifizieren desjenigen Aufnahmebereiches (126, 326, 426), in dem sich das bestimmte Gebinde (250, 350, 450) befindet, unter Berücksichtigung der ermittelten Signal-Laufzeit.

FIG 1

EP 1 981 327 A2

FIG 2

FIG 3

FIG 4

480

420

490

485  452

485

485

450

451

460

425, 426

**EP 1 981 327 A2**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 10119232 C1
- WO 2005020656 A2
- US 20040193302 A1